# EUROPÄISCHE PATENTSCHRIFT

(11) **EP 0 342 494 B1**
(45) Veröffentlichungstag und Bekanntmachung des Hinweises auf die Patenterteilung: **29.12.1993**
(21) Anmeldenummer: 89108371.9
(22) Anmeldetag: 10.05.1989
(51) Int. Cl.: G03F 7/004

(54) **Strahlungsempfindliches Gemisch und Verfahren zur Herstellung von Reliefmustern**
Light-sensitive composition and process for the formation of relief patterns
Composition photosensible et procédé pour la fabrication d'images en relief

(30) Priorität: 19.05.1988 DE 3817010
(43) Veröffentlichungstag der Anmeldung: 23.11.1989
(73) Patentinhaber: BASF Aktiengesellschaft, 67063 Ludwigshafen (DE)
(72) Erfinder: Schwalm, Reinhold, Dr., D-6706 Wachenheim (DE); Boettcher, Andreas, Dr., D-6907 Nussloch (DE); Fischer, Martin, Dr., D-6700 Ludwigshafen (DE); Binder, Horst, D-6840 Lampertheim (DE)

(56) Entgegenhaltungen:
- EP-A- 0 249 139
- DE-A- 3 628 046
- JP-A-62 038 450
- RESEARCH DISCLOSURE. no. 273, Januar 1987, HAVANT GB Seite 24 An.: "Aqueous-Base Developable Positive Resist Compositions"
- MICROELECTRONIC ENGINEERING. vol. 6, no. 1-4, Dezember 1987, AMSTERDAM NL Seiten 503 - 509; R.DAMMEL et al.: "Photocatalytic Novolak-Based Positive Resist for X-ray Lithography - Kinetics and Simulation"
- JOURNAL OF IMAGING TECHNOLOGY. vol. 11, no. 4, August 1985, SPRINGFIELD US Seiten 146 - 157; S.P.Papas: "Photogeneration of Acid:Part 6- A Review of Basic Principles for Resist Imaging Applications"

## Beschreibung

Die Erfindung betrifft positiv arbeitende strahlungsempfindliche Gemische, die ein wäßrigalkalisch lösliches Bindemittel, eine Verbindung, die mindestens eine durch Säure spaltbare Bindung enthält und unter Einwirkung von Strahlung eine starke Säure bildet, wobei die Löslichkeit der Verbindung in einem alkalischen Lösungsmittel durch die Einwirkung der Säure erhöht wird, sowie weitere nichtstrahlungsempfindliche Verbindungen mit durch Säure spaltbaren Bindungen enthalten. Diese Gemische sind sensitiv gegenüber UV-, Elektronen- und Röntgenstrahlen und eignen sich besonders als Resistmaterialien.

Positiv arbeitende strahlungsempfindliche Gemische sind bekannt. Kommerziell werden besonders positiv arbeitende Resistmaterialien, die o-Chinondiazide in wäßrig-alkalisch löslichen Bindemitteln, z.B. Novolaken oder Poly-(p-vinylphenol)en, enthalten, eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslösen, sind beispielsweise aus US-A-3,915,706 bekannt, worin Photoinitiatoren, die eine starke Säure erzeugen, die dann in einer Sekundärreaktion säurelabile Gruppen, wie Polyaldehydgruppierungen, spalten, beschrieben werden.

Strahlungsempfindliche Gemische von Polymeren mit säurelabilen Seitengruppen und photochemischen Säurespendern sind z.B. aus US-A-4,491,628 und FR-A-2,570,844 bekannt. Diese polymeren Bindemittel sind jedoch hydrophob und werden erst nach der Belichtung alkalilöslich.

Die Verwendung von Oniumsalzen als photochemische Säurespender in Resistmaterialien ist z.B. aus der erwähnten US 4,491,628 bekannt. Einen Überblick über die Anwendung in Resistmaterialien gibt Crivello in 'Org. Coatings and Appl. Polym. Sci., 48, Seiten 65-69 (1985).

Weiterhin sind strahlungsempfindliche Gemische auf Basis von säurespaltbaren Verbindungen bekannt, die als Bindemittel ein wäßrigalkalisch lösliches Polymer, sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (DE-A-3 406 927). Als fotochemisch eine starke Säure bildende Verbindungen werden Diazonium-, Phosphonium-, Sulfonium- und Iodonium-, sowie Halogenverbindungen genannt. Nachteilig bei diesen Photoinitiatoren ist, daß durch die Einwirkung der Strahlung neben den gebildeten Säuren keine Photoprodukte entstehen, die eine Erhöhung der Löslichkeit im alkalischen Entwickler ermöglichen.

In der DE-A-3 721 741 werden strahlungsempfindliche Gemische vorgeschlagen, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Für bestimmte Anwendungszwecke haben diese Systeme jedoch Nachteile. Beispielsweise hat in diesen Systemen die organische Verbindung zwei Aufgaben, nämlich die Löslichkeit des polymeren Bindemittels vor der Belichtung zu reduzieren und nach der Belichtung zu erhöhen und zweitens muß die Verbindung strahlungsempfindlich sein. Für bestimmte Anwendungen ist es jedoch vorteilhaft, den Anteil der photoaktiven organischen Verbindung zu reduzieren, z.B. um eine höhere Transparenz im kurzwelligen UV-Gebiet (im Bereich von 250 nm) zu erhalten, so daß die Aufgabe der Löslichkeitsinhibierung anders gelöst werden muß.

In der EP-A-0 249 139 werden Resist-Zusammensetzungen beschrieben, die ein in Wasser oder in wäßrigen Basen lösliches organisches Polymer, eine eine säurelabile Gruppe enthaltende Verbindung, die ein Löslichkeitsinhibitor für das wasserlösliche Polymer ist, beispielsweise eine tert.-Butylesterverbindung und ein Aryloniumsalz, wie z.B. ein Arylsulfonium- oder Aryljodoniumsalz enthalten. Das hierin beschriebene organische Polymere ist ein Novolak mit einem mittleren Molekulargewicht von 200 bis 20 000. Der Nachteil dieser Resistzusammensetzungen ist, daß die Novolake relativ niedrige Glastemperaturen aufweisen, daß sie im Bereich um 250 nm nicht genügend transparent sind und daß die Photoinitiatoren durch die Einwirkung von Strahlung neben den gebildeten Säuren keine Photoprodukte bilden, die eine Erhöhung der Löslichkeit im alkalischen Entwickler bewirken.

In der EP-A-0 146 411 werden photosolubilisierbare Gemische beschrieben, die aus einem alkalilöslichem Phenolharz und einem strahlungsempfindlichen Oniumsalz bestehen. Nachteilig an den hier beschriebenen Zusammensetzungen ist, daß ihre Transparenz ungenügend ist, ihre Empfindlichkeit relativ gering und der Kontrast zu schwach ist.

Aufgabe der vorliegenden Erfindung ist es, hochreaktive strahlungsempfindliche Systeme für die Herstellung von Reliefstrukturen zur Verfügung zu stellen, die sich mit wäßrig-alkalischen Lösungen entwickeln lassen, wobei die zur Löslichkeitsinhibierung des polymeren Bindemittels zugesetzten Verbindungen unter der Einwirkung von Strahlung ihre Löslichkeit in alkalischen Entwicklern erhöhen und die die Herstellung von lichtempfindlichen Schichten mit hoher Transparenz im kurzwelligen UV ermöglichen.

Überraschenderweise läßt sich diese Aufgabe durch die erfindungsgemäßen Gemische sehr vorteilhaft lösen.

Gegenstand der vorliegenden Erfindung ist ein strahlungsempfindliches Gemisch, enthaltend
(a) ein in Wasser unlösliches, in wäßrig-alkalischen Lösungen lösliches polymeres Bindemittel und
(b) eine organische Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält,
das dadurch gekennzeichnet ist, daß das polymere Bindemittel (a) Poly-(p-hydroxistyrol), Poly-(p-hydroxi-α-methylstyrol) oder ein Copolymeres von p-Hydroxistyrol und p-Hydroxi-α-methylstyrol ist und daß das strahlungsempfindliche Gemisch zusätzlich
(c) eine nicht photoempfindliche, mindestens eine durch Säure spaltbare Bindung enthaltende organische Verbindung, deren Löslichkeit in einem wäßrig-alkalischen Entwickler durch Einwirkung von Säure erhöht wird, oder
(d) eine nicht photoempfindliche, mindestens eine durch Säure spaltbare Bindung enthaltende organische Verbindung, die sich durch Einwirkung von Säure so zersetzt, daß sie durch Behandlung bei Temperaturen von 60 bis 120°C vollständig entfernt werden kann, oder ein Gemisch der nichtphotoempfindlichen organischen Verbindungen (c) und (d) enthält,
wobei als organische Verbindungen (b) Sulfoniumsalze der allgemeinen Formel (I) 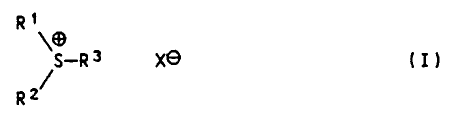
worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet, eingesetrt werden.

Bevorzugte, nicht photoempfindliche, mindestens eine durch Säure spaltbare Bindung enthaltende organische Verbindungen (c), deren Löslichkeit in einem wäßrig-alkalischen Entwickler durch Einwirkung von Säure erhöht wird, sind tert.-Butylcarbonat oder Silylether einer Hydroxiphenylverbindung der allgemeinen Formel (II) 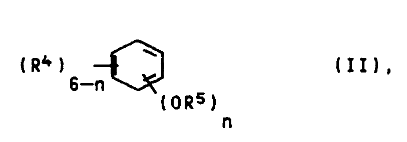
worin R⁴ für Wasserstoff, C₁- bis C₆-Alkyl, C₁- bis C₆-Alkoxi, Halogen, Phenyl oder einen anellierten aromatischen Rest, R⁵ für tert.-Butoxicarbonyl oder Trialkylsilyl stehen und n = 1 bis 3 sein kann.

Bevorzugte nicht photoempfindliche, mindestens eine durch Säure spaltbare Bindung enthaltende organische Verbindungen (d), die sich durch Einwirkung von Säure so zersetzen, daß sie durch Behandlung bei Temperaturen von 60 bis 120°C vollständig entfernt werden können, sind Derivate der Pyrokohlensäure oder der Ortho-Kohlensäure, insbesondere Pyrokohlensäuredialkylester und Tetraalkylorthocarbonate.

Gegenstand der vorliegenden Erfindung ist außerdem ein Verfahren zur Herstellung von Reliefmustern und Reliefbildern, wobei ein erfindungsgemäßes strahlungsempfindliches Gemisch eingesetzt wird, das vorzugsweise nach der Belichtung auf Temperaturen zwischen 60 und 120°C erhitzt wird.

Die erfindungsgemäßen strahlungsempfindlichen Gemische ermöglichen die Herstellung von lichtempfindlichen Schichten mit hoher Transparenz im kurzwelligen UV und ergeben eine sehr einheitliche Entwickelbarkeit.

Weiterhin ist die Empfindlichkeit der Systeme durch die katalytische Wirkung der photochemisch erzeugten Säuren sehr hoch (< 100 mJ/cm², abhängig vom Gehalt der Verbindungen b)) und es ergeben sich sehr hohe Kontraste. Diese strahlungsempfindlichen Gemische sind daher für die Anwendung in der Deep-UV Lithographie sehr gut geeignet.

Zu den Aufbaukomponenten des erfindungsgemäßen strahlungsempfindlichen Gemisches ist im einzelnen folgendes auszuführen.
(a) Das polymere Bindemittel (a) besteht im wesentlichen aus Poly-(p-hydroxistyrol), Poly-(p-hydroxi-α-methylstyrol) oder Copolymeren aus p-Hydroxistyrol und p-Hydroxi-α-methylstyrol und weist im allgemeinen mittlere Molekulargewichte M̅_{w} zwischen 2000 und 100 000, vorzugsweise zwischen 20 000 und 70 000 auf.
   Das polymere Bindemittel (a) ist im erfindungsgemäßen Gemisch im allgemeinen in einer Menge von 55 bis 90, vorzugsweise 70 bis 85 Gew.-%, bezogen auf die Summe der Komponenten (a) bis (d) enthalten.
(b) Als organische Verbindung (b), deren Löslichkeit in einem wäßrig-alkalischen Entwickler durch Einwirkung von Säure erhöht wird und die mindestens eine durch Säure spaltbare Gruppierung, die unter Einwirkung von Strahlung eine starke Säure bildet, enthält,
dient eine verbindung der allgemeinen Formel (I), 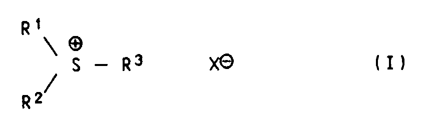
worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung, vorzugsweise t-Butylcarbonate von Phenolen bzw. Silylether von Phenolen enthält, wobei einer der Reste R¹ bis R³ mit einem oder mehreren weiteren Sulfoniumsalzresten, gegebenenfalls über durch Säure spaltbare Gruppierungen, verknüpft sein kann und X^{⊖} ein nichtnucleophiles Gegenion bedeutet.

Es können auch zwei oder mehrere Sulfoniumeinheiten im Molekrül über die Reste R¹ bis R³ verknüpft sein. Die organischen Verbindungen (b) werden im allgemeinen in Mengen von 5 bis 15, bevorzugt 5 bis 10 Gew.-%, bezogen auf die Gesamtmenge des strahlungsempfindlichen Gemisches, eingesetzt.

Bevorzugte Sulfoniumsalze der allgemeinen Formel (I) 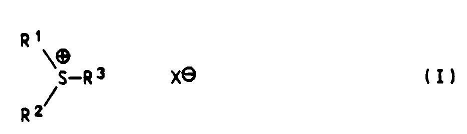
sind solche, in denen R¹ und R² für Methylgruppen und R³ für substituierte Phenylderivate mit säurespaltbaren Gruppen stehen. 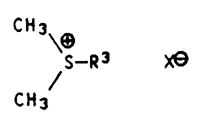
worin R³ z.B. für 4-t-Butoxicarbonyloxi-phenyl-, 4-t-Butoxicarbonyloxi-3,5-dimethyl-phenyl-, 4-t-Butoxicarbonyloxi-3-methyl-phenyl-, 4-t-Butoxicarbonyloxi-2-methyl-phenyl-, 4-t-Butoxicarbonyloxi-3,5-dimethoxi-phenyl-, 4-t-Butoxicarbonyloxi-3,5-diphenyl-phenyl-, 1-t-Butoxicarbonyloxi-naphthtyl-, 4-Trimethylsilyl-oxi-phenyl-, 4-Trimethylsilyl-oxi-naphthyl- stehen oder auch solche, in denen zwei der Reste R¹ bis R³ miteinander zu einem Ring, insbesondere einem fünf- oder sechsgliedrigen Ring verknüpft sind, wobei z.B. R¹ und R² beispielsweise zu Tetramethylengruppen verbrückt sind und R³ die gleiche Bedeutung wie vorstehend hat: 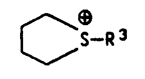
oder Verbindungen, in denen R¹ für Methyl und R² für Phenyl bzw. Tolyl stehen und R³ für ein substituiertes Phenylderivat mit säurespaltbaren Gruppen steht, wie 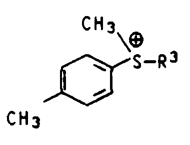
worin R³, für 4-t-Butoxicarbonyloxi-phenyl-, 2,4-Di-t-butoxicarbonyloxi-phenyl-, 4-t-Butoxicarbonyloxi-2-methoxi-phenyl-, 4-Trimethylsilylphenylsteht,
oder worin R¹ für Phenyl oder C₁- bis C₁₂-substituiertes Phenyl oder halogensubstituiertes Phenyl steht und R² und R³ substituierte Phenylderivate mit säurespaltbaren Gruppen sind, wie z.B. 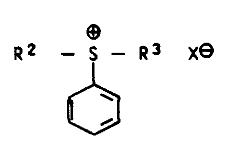
worin R² und R³ z.B. 4-t-Butoxicarbonyloxi-phenyl, 4-Trimethylsilyloxiphenyl-, 4-t-Butyl-dimethyl-silyloxi-phenyl-, 4-t-Butoxicarbonyloxi-3,5-dimethyl-phenyl- oder R¹, R² und R³ untereinander gleich sind, d.h. Sulfoniumsalze (b), in denen diese Reste mit säurespaltbaren Gruppen dreimal enthalten sind.

Weiterhin kommen auch Verbindungen der allgemeinen Formel (I) in Betracht, worin einer der Reste R¹ bis R³ mit einem oder mehreren weiteren Sulfoniumsalzresten, gegebenenfalls über durch Säure spaltbare Gruppierungen verknüpft ist, die also ebenfalls mehrere Sulfoniumgruppen im Molekül aufweisen, wie z.B. 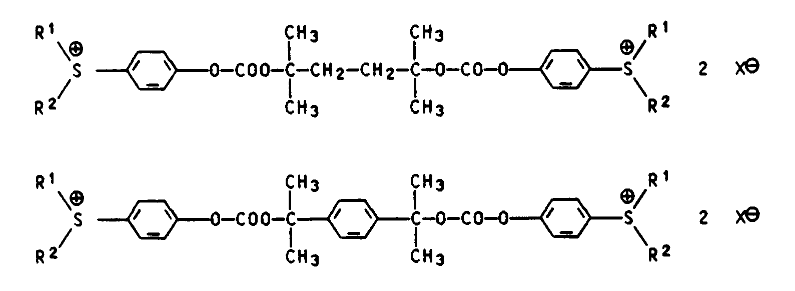
Als Gegenionen kommen bevorzugt komplexe Metallhalogenide, wie Tetrafluoroborat, Hexafluoroantimonat, Hexafluoroarsenat und Hexafluorophosphat in Betracht, jedoch ist die Erfindung nicht auf diese speziellen Gegenionen noch auf die aufgeführten Verbindungen mit säurespaltbaren Gruppen beschränkt, vielmehr können alle Verbindungen verwandt werden, welche unter Bestrahlung eine starke Säure bilden und im gleichen Molekül eine säurespaltbare Bindung enthalten.

Die organischen Verbindungen (b) können nach den bekannten Methoden der organischen Chemie zur Synthese von Estern, Ethern und Carbonaten hergestellt werden, indem man von den Sulfoniumsalzen mit phenolischen Gruppen ausgeht und diese entsprechend derivatisiert. Ausgehend von Sulfoniumsalzen mit phenolischen Gruppen können diese mit Kalium-t-butylat umgesetzt werden, anschließend kann mit Di-t-butyl-dicarbonat die säurespaltbare Gruppe eingeführt oder alternativ das phenolische Sulfoniumsalz mit einer aktivierten Carbonylverbindung, z.B. dem t-Butyloxi-carbonyl-N-imidazol, umgesetzt werden. Für diese Umsetzung eignen sich insbesondere Hydroxiphenyl-sulfoniumsalze, die bereits ein nichtnucleophiles Anion, wie z.B. Hexafluoroantimonat enthalten. Solche Verbindungen können beispielsweise nach einer Synthesevorschrift in J. Polym. Sci., Chem. Ed., 18, 1021 (1980), hergestellt werden. Man kann beispielsweise die so hergestellten Verbindungen im trockenem Tetrahydrofuran lösen, Kalium-t-butylat in trockenem Tetrahydrofuran zugeben und anschließend eine Lösung von Di-t-butyl-dicarbonat in Tetrahydrofuran zutropfen. Nach der Aufarbeitung und Umkristallisation enthält man dann die reinen Sulfoniumsalze mit säurelabilen Gruppen.

Bevorzugte Beispiele für organische Verbindungen (b) sind Dimethyl-4-t-butoxicarbonyloxiphenyl-sulfoniumsalz mit Hexafluoroarsenat, Hexafluoroantimonat, Hexafluorophosphat und/oder Hexafluoroborat als Gegenion, Phenyl-bis-(4-t-butoxitarbonyloxiphenyl-) sulfoniumsalz mit den genannten Gegenionen, Tris-(4-t-butoxicarbonyloxiphenyl-) sulfoniumsalz mit den genannten Gegenionen oder 1-Naphthyl-4-trimethylsilyloxitetramethylen-sulfoniumsalz mit den genannten Gegenionen.
(c) Als nichtphotoempfindlichen mindestens eine durch Säure spaltbare Bindung enthaltende organische Verbindung (c), deren Löslichkeit in einem wäßrig-alkalischen Entwickler durch Einwirkung von Säure erhöht wird, kommen vorzugsweise tert.-Butylcarbonate oder Silylether von Hydroxiphenylverbindungen der allgemeinen Formel (II) in Frage,

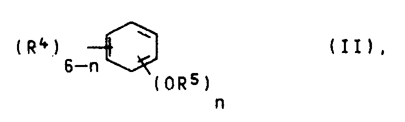

worin R⁴ für Wasserstoff, C₁- bis C₆-Alkyl, vorzugsweise C₁- bis C₆-Alkoxi, vorzugsweise H, oder Halogen, Phenyl- oder einen anellierten aromatischen Rest, wie z.B. Naphthyl, R⁵ für tert.-Butoxicarbonyl oder Trialkylsilyl mit 1 bis 6 Kohlenstoffatomen in den Alkylgruppen, vorzugsweise Methylgruppen, stehen und n = 1 bis 3 sein kann, wie beispielsweise 4-t-Butyloxicarbonyloxi-1-t-butyl-benzol, 4-t-Butoxicarbonyloxi-3,5-dimethoxibenzol, Trimethylsilyloxi-4-chloro-benzol, 1,4-bis-(t-Butoxicarbonyloxi-)benzol, 1,3,5-tris-(t-Butoxicarbonyloxi-)benzol, 1,3,5-tris(trimethylsilyloxi-)benzol und 1-t-Butoxicarbonyloxi-5,6,7,8-tetrahydronaphthalin.

Die Erfindung ist jedoch nicht auf diese spezielle Auswahl der oben genannten Verbindungen (c) beschränkt, vielmehr kommen eine Reihe weiterer phenolischer t-Butylcarbonate und Silylether in Frage, wenn die spezielle Bedingung der hohen Transparenz in kurzwelligen UV-Bereich nicht erfüllt werden muß, wie beispielsweise 1,4,9,10-tetra-(t-Butoxicarbonyloxi-)anthracen, 1,2,5,8-tetra-(t-Butoxicarbonyloxi-)anthrachinon, 2,2',4,4'-tetra-t-butoxicarbonyloxi-)benzophenon und 1,8,9-tris(trimethylsilyloxi-)anthracen.

Die Verbindungen (c) können nach den bekannten Methoden der organischen Chemie zur Synthese von Estern, Ethern und Carbonaten hergestellt werden, indem man von Aromaten mit phenolischen Gruppen ausgeht und diese entsprechend derivatisiert.

### Beispiel für die Synthese einer Verbindung (c): Herstellung von 1,4-di-(t-butoxicarbonyloxi-)benzol

In einem 1l-Dreihalskolben werden 200 ml trockenes Tetrahydrofuran (=THF) vorgelegt und ein schwacher Stickstoffstrom durchgeleitet. Dann werden 22,0 g Hydrochinon eingetragen und, nachdem sich alles gelöst hat, 44,8 g Kalium-t-butylat zugegeben. Nach ca. 10 Minuten Reaktionszeit werden 90,5 g Di-t-butyl-dicarbonat in 100 ml THF langsam zugetropft. Nach beendeter Zugabe läßt man noch eine Stunde rühren.
Die Reaktionsmischung wird in 2 l Eiswasser gegeben und mit 2 l Essigsäure-ethylester portionsweise extrahiert. Die organische Phase wird mit 6 l Wasser portionsweise gewaschen und über Magnesiumsulfat getrocknet. Nach dem Abziehen des Lösungsmittels wird aus Ethanol umkristallisiert. Ausbeute: 11,2 g

| | | | | |
|---|---|---|---|---|
| Elementaranalyse | gef.: | C 61.8 | H 7.2 | 0 30.7 |
| | ber.: | C 61.9 | H 7.2 | 0 30.9 |

Schmelzpunkt: 142°C (DSC)
1-H NMR s 1.6 ppm (18 H), s 7.2 ppm (4 H)
Analog können alle anderen phenolischen Verbindungen mit t-Butylcarbonatgruppierungen hergestellt werden.

Die Verbindungen mit Trialkylsilylgruppierungen lassen sich durch Reaktion der entsprechenden phenolischen Verbindungen mit Hexamethyl-disilazan oder anderen Silylierungsreagenzien herstellen.

### Beispiel für die Synthese von Tris-1,3,5-(trimethylsilyloxi-)benzol:

In einen 100 ml Rundkolben werden 5,0 g 1,3,5-Trihydroxybenzol und 25,0 g Hexamethyl-disilazan gegeben und 6 Stunden bei 100°C gehalten. Danach wird das überschüssige Hexamethyl-disilazan im Vakuum entfernt und der flüssige Rückstand fraktioniert destilliert. Das IR-Spektrum hat keine OH-Banden; starke Aliphatenbanden bei 2900 cm⁻¹ sowie Si-methyl-Banden bei 1260 cm⁻¹ und 850 cm⁻¹.

| | | | | |
|---|---|---|---|---|
| Elementaranalyse | gef.: | C 52.4 | H 8.9 | Si 21.8 |
| | ber.: | C 52.6 | H 8.8 | Si 24.6 |

(d) Als nichtphotoempfindliche, mindestens eine durch Säure spaltbare Bindung enthaltende organische Verbindungen, die sich durch Einwirkung von Säure so zersetzen, daß sie durch Behandlung bei Temperaturen von 60 bis 120°C vollständig entfernt werden können, kommen vorzugsweise Derivate der Pyrokohlensäure oder der Orthokohlensäure in Betracht, beispielsweise Pyrokohlensäuredialkylester mit 1 bis 8, vorzugsweise 1 bis 5 Kohlenstoffatomen in den Alkylgruppen, wie Pyrokohlensäure-dimethylester, Pyrokohlensäurediethylester, Pyrokohlensäure-di-tert.-butylester, Pyrokohlensäure-di-tert.-amylester sowie Tetraalkylorthocarbonate mit 1 bis 6, vorzugsweise 1 bis 4 Kohlenstoffatomen in den Alkylgruppen, beispielsweise Tetraethylorthocarbonat und/oder Tetramethylorthocarbonat.
   Die Verbindungen (d) sind kommerziell erhältliche Produkte (Hersteller z.B. die Firmen Aldrich, Fluka oder Merck).

Die Verbindungen (c) und/oder (d) sind im erfindungsgemäßen strahlungsempfindlichen Gemisch im allgemeinen in Mengen von 5 bis 30, vorzugsweise 10 bis 20 Gew.-%, bezogen auf die Gesamtmenge des strahlungsempfindlichen Gemisches enthalten.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV- bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man die 254 nm Linie oder man verwendet Excimer-Laser, die bei 248 nm (KrF) ermittieren. Strahlungsempfindliche Aufzeichnungsmaterialien sollten deshalb in diesem Bereich möglichst niedrige optische Dichten aufweisen.

Zur Absorption des polymeren Bindemittels (a) addiert sich die Absorption der Verbindungen (b): beispielsweise haben Verbindungen wie Phenyl-bis-(t-butoxicarbonyloxiphenyl-)sulfoniumhexafluoroarsenat oder Tris-(t-butoxicarbonyloxiphenyl-)sulfoniumhexafluoroarsenat Extinktionskoeffizienten > 5000.

Um eine Löslichkeitsinhibierung durch diese Komponenten zu erhalten, muß man jedoch deutlich mehr als 10 Gew.-% dieser Verbindungen zum Bindemittel geben, so daß sich optischen Dichten im Bereich um 1 pro µm Schichtdicke oder höher ergeben.

Überraschenderweise läßt sich jedoch der Anteil der Verbindungen (b) reduzieren, wenn man als Löslichkeitsinhibitoren nichtphotoempfindliche Komponenten des Typs (c) oder (d) zusätzlich verwendet. Die Verbindungen des Typs (c) lassen sich durch die Einwirkung von Säure, die durch die Fotoreaktion der Verbindungen (b) gebildet wird, so in ihrem Löslichkeitsverhalten verändern, daß aus den hydrophoben Ausgangsverbindungen alkalilösliche Produkte entstehen. In den belichteten Bereichen entstehen also durch die Einwirkung der Strahlung alkalilösliche Produkte sowohl aus den photoempfindlichen Verbindungen (b) als auch aus den Verbindungen (c).

Durch den Zusatz der Verbindungen (c) kann die optische Dichte (OD) im Wellenlängenbereich um 250 nm wesentlich verbessert werden:

| | | |
|---|---|---|
| Bindemittel Poly-(p-hydrixistyrol) | OD (248 nm) | 0,22/µm |
| Poly-(p-hydroxistyrol) + 20 Gew.-% Tris(t-butoxicarbonyloxiphenyl-) sulfonium hexafluoroarsenat | OD (248 nm) | 0,95/µm |
| Poly-(p-hydroxistyrol) + 5 Gew.-% Tris(t-butoxicarbonyloxiphenyl-) sulfonium hexafluoroarsenat + 15 Gew.-% 1,3,5-tri-(t-butoxicarbonyloxi-)benzol | OD (248 nm) | 0,50/µm |

Bei dem erfindungsgemäßen Verfahren zur Herstellung von Reliefmustern und Reliefbildern wird eine strahlungsempfindliche Aufzeichnungsschicht, die im wesentlichen aus dem erfindungsgemäßen strahlungsempfindlichen Gemisch besteht, das zweckmäßigerweise in einem inerten Lösungsmittel, wie z.B. Methyl-propylenglykolacetat, Methylcellosolveacetat oder Ethylcellosolveacetat gelöst, in üblicher Weise, beispielsweise durch Aufschleudern (spin coating) auf ein geeignetes Substrat, wie z.B. einen Siliciumwafer in Schichtdicken (trocken gemessen) von 0,2 bis 4 µm aufgetragen und getrocknet wurde, bildmäßig in solcher Dosis bestrahlt und bei Temperaturen von 60 bis 120°C während 5 Sekunden bis 5 Minuten ausheizt, so daß die Löslichkeit der belichteten Bereiche in wäßrig-alkalischen Lösungsmitteln, beispielsweise alkalischen Entwicklern von pH 10-14, enthaltend Alkali-hydroxide, Alkalisilikate oder Amine, wie Tetramethylammonium-hydroxid, zunimmt und diese bestrahlten Bereiche selektiv mit dem alkalischen Entwickler entfernt werden können.

Die Gemische weisen hohe Empfindlichkeit und Kontraste auf. Es entstehen Reliefstrukturen guter Strukturqualität.

Die in den Beispielen genannten Teile und Prozente sind, soweit nicht anders angegeben, Gewichtsteile und Gewichtsprozente.

### Beispiel 1:

Eine Photoresistlösung wird aus 5 Teilen Tris-(4-t-butoxicarbonyloxiphenyl-)sulfoniumhexafluoroarsenat, 15 Teilen 1,3,5-Tri-(t-butoxicarbonyloxi-)benzol, 80 Teilen Poly-(p-hydroxystyrol) und 300 Teilen Methyl-propylenglykol-acetat hergestellt. Die Lösung wird anschließend durch ein Filter mit einem Porendurchmesser von 0,2 µm filtriert.

Diese Resistlösung wird auf einen Siliciumwafer mit einem SiO₂-Film in einer Schichtdicke von ca. 1,0 µm aufgeschleudert. Der Wafer wird eine Minute bei 90°C getrocknet, anschließend mit einer bildmäßig strukturierten Testmaske in Kontakt gebracht und 3 Sekunden mit Excimer-Laserlicht der Wellenlänge 248 nm belichtet. Danach wird 60 Sekunden bei 80°C aufgeheizt und mit einem Entwickler vom pH-Wert 13,00 30 Sekunden entwickelt. Die belichteten Bereiche sind vollständig abgetragen, während kein Abtrag der unbelichteten Bereiche gemessen wird. Die Resistmuster zeigen vertikale Flanken.

### Vergleichsbeispiel (ohne Zusatz der Verbindungen (c) oder (d))

Eine Photoresistlösung wird aus 20 Teilen Tris-(4-t-butoxicarbonyloxiphenyl-)sulfoniumhexafluoroarsenat, 80 Teilen Poly-(p-hydroxistyrol) und 300 Teilen Methyl-propylenglykol-acetat hergestellt. Es wird wie in Beispiel 1 verfahren, jedoch muß man 8 Sekunden belichten, um die belichteten Bereiche unter den gleichen Bedingungen vollständig abzutragen. Die Resistprofile weisen schräge Kanten auf.

### Beispiel 2

Es wird eine Fotoresistlösung aus 0,25 Teilen Phenyl-bis-(4-t-butoxicarbonyloxiphenyl)sulfoniumhexafluoroarsenat, 1 Teil Di-t-butyldicarbonat, 1 Teil Poly-(p-hydroxistyrol) und 5,75 Teilen Diethylenglykol-dimethylether hergestellt. Die Lösung wird durch ein Filter mit einem Porendurchmesser von 0,2 µm filtriert.

Auf eine Natriumchloridplatte wird eine Schicht von ca. 5 µm Dicke aufgeschleudert. Nach dem Erhitzen der NaCl-Platte bei 80°C (60 Sekunden) zeigt das IR-Spektrum zwei Carbonylbanden des Dicarbonats bei 1760 cm und 1800 cm. Nach dem weiteren Ausheizen des Natriumchloridplättchens während 60 Sekunden bei 90°C geht die Bande um 40 % zurück. Eine Schicht der Resistlösung auf einem Wafer zeigt unter den gleichen Aufheizbedingungen während 30 Sekunden Entwicklung mit einem Entwickler vom pH 13,0 nur etwa 5 % Schichtdickenabtrag.

Schleudert man jedoch eine ca. 5 µm dicke Schicht auf eine NaCl-Platte, heizt bei 80°C (60 Sekunden) aus, belichtet 20 Sekunden mit Excimer-Laserlicht der Wellenlänge 248 nm und heizt anschließend 60 Sekunden bei 90°C aus, so sind die Carbonylbanden bei 1800 cm und 1760 cm vollständig verschwunden. Eine analog behandelte Schicht auf einem Siliciumwafer löst sich während 20 Sekunden vollständig in dem Entwickler vom pH 13,0.

## Patentansprüche

1. Strahlungsempfindliches Gemisch, enthaltend
(a) ein in Wasser unlösliches, in wäßrig-alkalischen Lösungen lösliches polymeres Bindemittel und
(b) eine organische Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält,
dadurch gekennzeichnet, daß das polymere Bindemittel (a) Poly-(p-hydroxistyrol), Poly-(p-hydroxi-α-methylstyrol) oder ein Copolymeres von p-Hydroxistyrol und p-Hydroxi-α-methylstyrol ist, und das strahlungsempfindliche Gemisch zusätzlich
(c) eine nicht photoempfindliche, mindestens eine durch Säure spaltbare Bindung enthaltende organische Verbindung, deren Löslichkeit in einem wäßrig-alkalischen Entwickler durch Einwirkung von Säure erhöht wird, oder
(d) eine nicht photoempfindliche, mindestens eine durch Säure spaltbare Bindung enthaltende organische Verbindung, die sich durch Einwirkung von Säure so zersetzt, daß sie durch Behandlung bei Temperaturen von 60 bis 120°C vollständig entfernt werden kann, oder ein Gemisch der nichtphotoempfindlichen organischen Verbindungen (c) und (d) enthält,
wobei als organische Verbindung (b) ein Sulfoniumsalz der allgemeinen Formel (I) 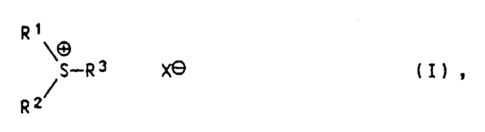 worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet, eingesetzt wird.

2. Strahlungsempfindliches Gemisch nach
Anspruch 1, dadurch gekennzeichnet, daß als nicht photoempfindliche, mindestens eine durch Säure spaltbare Bindung enthaltende organische Verbindung (c), deren Löslichkeit in einem wäßrig-alkalischen Entwickler durch Einwirkung von Säure erhöht wird, mindestens ein tert.-Butylcarbonat oder Silylether einer Hydroxiphenylverbindung der allgemeinen Formel (II) 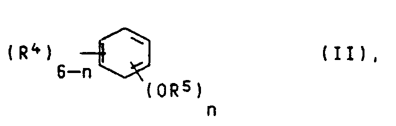 worin R⁴ für Wasserstoff, C₁- bis C₆-Alkyl, C₁- bis C₆-Alkoxi, Halogen, Phenyl oder einen anellierten aromatischen Rest, R⁵ für tert.-Butoxicarbonyl oder Trialkylsilyl stehen und n = 1 bis 3 sein kann, eingesetzt wird.

3. Strahlungsempfindliches Gemisch nach einem der vorhergehenden Ansprüche, dadurch gekennzeichnet, daß als nicht photoempfindliche, mindestens eine durch Säure spaltbare Bindung enthaltende organische Verbindung (d), die sich durch Einwirkung von Säure so zersetzt, daß sie durch Behandlung bei Temperaturen von 60 bis 120°C vollständig entfernt werden kann, mindestens ein Derivat der Pyrokohlensäure oder der Orthokohlensäure eingesetzt wird.

4. Strahlungsempfindliches Gemisch nach Anspruch 3, dadurch gekennzeichnet, daß die nicht photoempfindliche organische Verbindung (d) Pyrokohlensäuredialkylester oder ein Tetraalkylorthocarbonat ist.

5. Verfahren zur Herstellung von Reliefmustern und Reliefbildern, dadurch gekennzeichnet, daß man als lichtempfindliche Beschichtungsmaterialien ein strahlungsempfindliches Gemisch gemäß einem der vorhergehenden Ansprüche einsetzt.

6. Verfahren zur Herstellung von Reliefmustern nach Anspruch 5, dadurch gekennzeichnet, daß nach der Belichtung des strahlungsempfindlichen Gemisches auf Temperaturen zwischen 60 und 120°C erhitzt wird.

## Claims

1. A radiation sensitive mixture comprising
(a) a polymeric binder which is insoluble in water but soluble in aqueous alkaline solutions and
(b) an organic compound whose solubility in an aqueous alkaline developer is increased by the action of acid and which contains at least one acid cleavable group and additionally a group which forms a strong acid on irradiation,
wherein the polymeric binder (a) is poly(p-hydroxystyrene), poly(p-hydroxy-α-methylstyrene) or a copolymer of p-hydroxystyrene and p-hydroxy-α-methylstyrene and which further comprises
(c) a nonphotosensitive organic compound which contains at least one acid cleavable bond and the solubility of which in an aqueous alkaline developer is increased by the action of acid, or
(d) a nonphotosensitive organic compound which contains at least one acid cleavable bond and which by the action of acid decomposes in such a way as to be completely removable by treatment at from 60 to 120°C, or a mixture of the nonphotosensitive organic compounds (c) and (d), and
wherein the organic compound (b) is a sulfonium salt of the general formula (I) 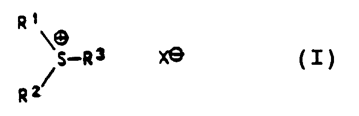 where R¹, R² and R³ are identical to or different from one another and each is singly acyclyl or aryl with or without hetero atoms, or two of R¹ to R³ together form a ring, with the proviso that at least one of R¹ to R³ contains one or more acid cleavable groups, one of R¹ to R³ may be linked to one or more further sulfonium salt residues directly or via acid cleavable groups, and X^{⊖} is a nonnucleophilic counterion.

2. A radiation sensitive mixture as claimed in claim 1, wherein the nonphotosensitive organic compound (c) which contains at least one acid cleavable bond and the solubility of which in an aqueous alkaline developer is increased by the action of acid is at least one tert.-butyl carbonate or silyl ether of a hydroxyphenyl compound of the general formula (II) 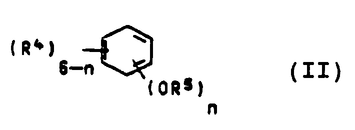 where R⁴ is hydrogen, C₁-C₆-alkyl, C₁-C₆-alkoxy, halogen, phenyl or fused-on aryl, R⁵ is tert.-butoxycarbonyl or trialkylsilyl, and n is from 1 to 3.

3. A radiation sensitive mixture as claimed in either of the preceding claims, wherein the nonphotosensitive organic compound (d) which contains at least one acid cleavable bond and which by the action of acid decomposes in such a way as to be completely removable by treatment at from 60 to 120°C is at least one derivative of pyrocarbonic acid or of orthocarbonic acid.

4. A radiation sensitive mixture as claimed in claim 3, wherein the nonphotosensitive organic compound (d) is a dialkyl pyrocarbonate or a tetraalkyl orthocarbonate.

5. A process for producing a relief pattern or relief image, which comprises using a radiation sensitive mixture as claimed in any of the preceding claims as the light sensitive recording material.

6. A process for producing a relief pattern as claimed in claim 5, wherein the exposed radiation sensitive mixture is heated to from 60 to 120°C.

## Revendications

1. Mélange sensible aux rayonnements, contenant
a) un liant polymère insoluble dans l'eau mais soluble dans les solutions aqueuses alcalines, et
b) un composé organique dont la solubilité dans un révélateur aqueux alcalin est accrue sous l'action d'un acide et qui contient au moins un groupement scindable par les acides et également un groupement qui forme un acide fort sous l'action d'un rayonnement, caractérisé en ce que le liant polymère (a) consiste en poly-(p-hydroxystyrène), poly-(p-hydroxy-α-méthylstyrène), ou en un copolymère du p-hydroxystyrène et du p-hydroxy-α-méthylstyrène, et en ce que le mélange sensible aux rayonnements contient en outre
c) un composé organique non photosensible, contenant au moins une liaison scindable par un acide, dont la solubilité dans un révélateur aqueux alcalin est accrue sous l'action d'un acide, ou bien
d) un composé organique non photosensible, contenant au moins une liaison scindable par un acide, et qui se décompose sous l'action d'un acide au point de pouvoir être éliminé totalement par traitement à des températures de 60 à 120°C, ou bien un mélange des composés organiques non photosensibles c) et d),
le composé organique b) consistant en un sel de sulfonium de formule générale I 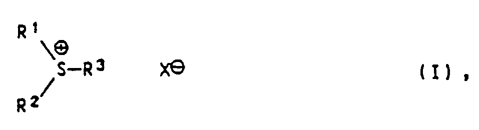 dans laquelle R¹, R² et R³, ayant des significations identiques ou différentes, représentent chacun un radical aliphatique et/ou aromatique contenant éventuellement des hétéroatomes, ou bien deux des groupes R¹ à R³ sont reliés entre eux en formant un cycle, sous réserve qu'au moins un des radicaux R¹ à R³ contient au moins un groupement scindable sous l'action d'un acide, l'un des radicaux R¹ à R³ pouvant être relié avec un ou plusieurs autres radicaux de sels de sulfonium, éventuellement par l'intermédiaire de groupements scindables sous l'action d'un acide, et X^{ϑ} représente un ion correspondant non nucléophile.

2. Mélange sensible aux rayonnements selon la revendication 1, caractérisé en ce que l'on utilise en tant que composé organique c) non photosensible contenant au moins une liaison scindable sous l'action d'un acide et dont la solubilité dans un révélateur aqueux alcalin est accrue sous l'action d'un acide, au moins un ter-butyl-carbonate ou un éther silylique d'un composé hydroxyphénylique de formule générale II 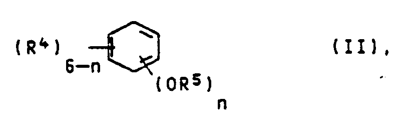 dans laquelle R⁴ représente l'hydrogène, un groupe alkyle en C1-C6, alcoxy en C1-C6, un halogène, un groupe phényle ou un radical aromatique condensé, R⁵ représente un groupe tert-butoxycarbonyle ou trialkylsilyle et n = 1 à 3.

3. Mélange sensible aux rayonnements selon une des revendications qui précèdent, caractérisé en ce que l'on utilise en tant que composé organique d) non photosensible contenant au moins une liaison scindable sous l'action d'un acide et qui se décompose sous l'action d'un acide au point de pouvoir être éliminé complètement par traitement à des températures de 60 à 120°C, au moins un dérivé de l'acide pyrocarbonique ou de l'acide orthocarbonique.

4. Mélange sensible aux rayonnements selon la revendication 3, caractérisé en ce que le composé organique non photosensible d) est un pyrocarbonate de dialkyle ou un orthocarbonate de tétraalkyle.

5. Procédé pour la fabrication de modèles en relief et d'images en relief, caractérisé en ce que l'on utilise en tant que matériau de revêtement photosensible un mélange sensible aux rayonnements selon l'une des revendications qui précèdent.

6. Procédé pour la fabrication de modèles en relief selon la revendication 5, caractérisé en ce que, après exposition à la lumière du mélange sensible aux rayonnements, on chauffe à des températures de 60 à 120°C.
